# EUROPEAN PATENT APPLICATION

(11) **EP 4 604 683 A1**
(43) Date of publication of application: **20.08.2025**
(21) Application number: 23890008.8
(22) Date of filing: 24.02.2023
(51) Int. Cl.: H05K 7/20

(54) **LIQUID COOLING SYSTEM, LIQUID COOLING SYSTEM CONTROL SYSTEM AND METHOD**

(30) Priority: 14.11.2022 CN 202211422934
(71) Applicant: Vertiv Corporation, Westerville, OH 43082 (US)
(72) Inventor: HUANG, Likui, Xi'an, Shaanxi 710005 (CN); TENG, Jie, Xi'an, Shaanxi 710005 (CN); XIE, Kai, Xi'an, Shaanxi 710005 (CN); LIU, Jia, Xi'an, Shaanxi 710005 (CN); CHENG, Yue, Xi'an, Shaanxi 710005 (CN); WAN, Jiqing, Xi'an, Shaanxi 710005 (CN)
(74) Representative: Harden, Henry Simon
(86) International application number: PCT/CN2023/078053
(87) International publication number: WO 2024/103560

(57) **Abstract**

A liquid cooling system, and a liquid cooling system control system and method. The liquid cooling system comprises a heat exchange unit and a cooling unit; the cooling unit comprises at least two separated cavities; the cooling unit is provided with at least two liquid inlets and at least two liquid outlets; one liquid inlet and one liquid outlet both correspond to and are communicated with one cavity; each cavity is communicated with the heat exchange unit by means of the corresponding liquid inlet and outlet, and a cooling loop is formed; and the liquid inlets and the liquid outlets each are provided with a first regulation valve, and a liquid inlet end of the heat exchange unit is provided with a second regulation valve. The liquid cooling system consumes less energy.

## Description

This application claims the priority benefit of Chinese Patent Application No. 202211422934.5 for invention entitled "LIQUID COOLING SYSTEM, LIQUID COOLING SYSTEM CONTROL SYSTEM AND METHOD", filed on November 14, 2022 with the China Patent Office, the disclosure of which is incorporated herein in its entirety by reference.

### FIELD OF THE INVENTION

The present invention relates generally to the field of refrigeration technology, and particularly, to a liquid cooling system, and a control system and method for the liquid cooling system.

### BACKGROUND OF THE INVENTION

With the development of technologies such as the Internet and cloud computation, the number of high-density cabinets applied in data centers (commonly referred to as computer rooms) has gradually increased, integration of equipment has been higher and higher, and power consumption has been larger and larger. The safe operation of a server, which is core equipment of a data center, depends on an excellent cooling system.

In related technologies, a server is placed in a cabinet, there is a coolant in the cabinet, the server is immersed in the coolant, and circulation of the coolant is realized by a pump, thereby satisfying continuous heat dissipation requirements of the server.

However, an amount of energy consumption of the above-mentioned liquid cooling system is larger.

### SUMMARY OF THE INVENTION

The present invention provides a liquid cooling system, and a control system and method for the liquid cooling system, with a smaller amount of energy consumption.

In a first aspect, the present invention provides a liquid cooling system, comprising a heat exchange unit and a cooling unit, wherein the cooling unit comprises at least two cavities separated from each other, the cooling unit is provided thereon with at least two liquid inlets and at least two liquid outlets, one of the liquid inlets and one of the liquid outlets both correspond to one cavity and are communicated with each other;
each of the cavities is communicated with the heat exchange unit through the corresponding liquid inlet and liquid outlet to form a cooling loop;
each of the liquid inlets and each of the liquid outlets are provided with a first regulating valve, and a liquid inlet end of the heat exchange unit is provided with a second regulating valve.

The liquid cooling system provided by the present invention is provided with a heat exchange unit and a cooling unit. The cooling unit has at least two cavities separated from each other. The cooling unit is provided thereon with at least two liquid inlets and at least two liquid outlets. One of the liquid inlets and one of the liquid outlets both correspond to one cavity and are communicated with each other. Each of the cavities is communicated with the heat exchange unit through corresponding liquid inlet and liquid outlet to form a cooling loop. Each of the liquid inlets and each of the liquid outlets are provided with a first regulating valve, and a liquid inlet end of the heat exchange unit is provided with a second regulating valve. In this way, the opening and closing of the first regulating valve can adjust a flow rate of a coolant involved in circulation, and the second regulating valve can adjust a flow rate of a coolant entered from the heat exchange unit to the cooling unit, which is helpful for reducing energy consumption required for coolant circulation and heat exchange in the cooling loop.

In one possible implementation, in the liquid cooling system provided by the present invention, the heat exchange unit comprises a first liquid pump and a heat exchanger, a liquid inlet end of the first liquid pump forms a liquid inlet end of the heat exchange unit, the first liquid pump is connected to the heat exchanger, and the first liquid pump is connected to each of the liquid outlets while the heat exchanger is connected to each of the liquid inlets.

In one possible implementation, the liquid cooling system provided by the present invention further comprises a filter, wherein a liquid inlet end of the filter is connected to a liquid outlet end of the first liquid pump, and a liquid outlet end of the filter is connected to a liquid inlet end of the first liquid pump, or
the liquid inlet end of the filter is connected to the cooling unit, and the liquid outlet end of the filter is connected to the liquid inlet end of the first liquid pump.

In one possible implementation, in the liquid cooling system provided by the present invention, a liquid inlet end of the second regulating valve is connected to a liquid outlet end of the first liquid pump, and a liquid outlet end of the second regulating valve is connected to the liquid inlet end of the first liquid pump.

In one possible implementation, in the liquid cooling system provided by the present invention, the cooling unit comprises at least two first subunits, and the first subunit has one cavity.

In one possible implementation, in the liquid cooling system provided by the present invention, the cooling unit comprises at least one second subunit, and the second subunit has at least two cavities.

In one possible implementation, in the liquid cooling system provided by the present invention, the second subunit comprises a cabinet, a liquid inlet pipe, and a liquid outlet pipe, an inner cavity of the cabinet is provided with at least one partition which separates the inner cavity into at least two cavities, both the liquid inlets and the liquid outlets are arranged on the cabinet;
the liquid inlet pipe and the liquid outlet pipe are located on two opposite sides of the cabinet, the liquid inlets are each communicated with the liquid inlet pipe, and the liquid outlets are each communicated with the liquid outlet pipe.

In one possible implementation, in the liquid cooling system provided by the present invention, both the liquid inlets and the liquid outlets are close to a top of the cooling unit; or
one group of the liquid inlets and the liquid outlets is close to the top of the cooling unit, and the other group of the liquid inlets and the liquid outlets is close to a bottom of the cooling unit.

In one possible implementation, the liquid cooling system provided by the present invention further comprises a fluid distributor being located between the cooling unit and the heat exchange unit, which are both connected to the fluid distributor.

In one possible implementation, the liquid cooling system provided by the present invention further comprises a liquid replenishing unit, which comprises a liquid storage tank and a second liquid pump, the second liquid pump being connected to the liquid storage tank, and the second liquid pump being connected to the first liquid pump.

In a second aspect, the present invention provides a control method for a liquid cooling system, which is used to control the above-mentioned liquid cooling system provided in the first aspect, the control method comprising:
acquiring an operating parameter of the liquid cooling system;
adjusting a rotation speed of a first liquid pump and/or an opening degree of a second regulating valve in a case where the operating parameter does not fall within a preset range.

The control method, for a liquid cooling system provided by the present invention, comprises acquiring an operating parameter of the liquid cooling system, and adjusts a rotation speed of a first liquid pump and/or an opening degree of a second regulating valve in a case where the operating parameter does not fall within a preset range. In this way, a flow rate of a coolant entered from a heat exchange unit to a cooling unit can be adjusted, which is helpful for reducing energy consumption required for coolant circulation and heat exchange in a cooling loop.

In one possible implementation, in the control method for a liquid cooling system provided by the present invention, the acquiring of an operating parameter of the liquid cooling system comprises:
acquiring a first pressure of a coolant at a liquid inlet end of the first liquid pump and a second pressure of a coolant at a liquid outlet end of the first liquid pump to obtain a difference value between the second pressure and the first pressure.

In one possible implementation, in the control method for a liquid cooling system provided by the present invention, the acquiring of an operating parameter of the liquid cooling system comprises:
acquiring a first flow rate of a coolant at a liquid inlet end of the first liquid pump and a second flow rate of a coolant at a liquid outlet end of the first liquid pump to obtain a difference value between the second flow rate and the first flow rate.

In one possible implementation, in the control method for a liquid cooling system provided by the present invention, the acquiring of an operating parameter of the liquid cooling system comprises:
acquiring a first temperature of a coolant at a liquid inlet end of the first liquid pump.

In one possible implementation, in the control method for a liquid cooling system provided by the present invention, the adjusting of a rotation speed of the first liquid pump and/or an opening degree of the second regulating valve in a case where the operating parameter does not fall within a preset range comprises:
in a case where the difference value between the second pressure and the first pressure is greater than a maximum value of a first preset range, decreasing the rotation speed of the first liquid pump; in a case where the difference value between the second pressure and the first pressure is less than a minimum value of the first preset range, increasing the rotation speed of the first liquid pump; or
in a case where the difference value between the second pressure and the first pressure is greater than the maximum value of the first preset range, increasing the opening degree of the second regulating valve; in a case where the difference value between the second pressure and the first pressure is less than the minimum value of the first preset range, decreasing the opening degree of the second regulating valve; or
in a case where the difference value between the second pressure and the first pressure is greater than the maximum value of the first preset range, decreasing the rotation speed of the first liquid pump; in a case where the rotation speed of the first liquid pump is decreased to a threshold value and the difference value between the second pressure and the first pressure is still greater than the maximum value of the first preset range, increasing the opening degree of the second regulating valve;
in a case where the difference value between the second pressure and the first pressure is less than the minimum value of the first preset range, decreasing the opening degree of the second regulating valve; in a case where the second regulating valve is closed and the difference value between the second pressure and the first pressure is still less than the minimum value of the first preset range, increasing the rotation speed of the first liquid pump.

In one possible implementation, in the control method for a liquid cooling system provided by the present invention, the adjusting of a rotation speed of the first liquid pump and/or an opening degree of the second regulating valve in a case where the operating parameter does not fall within a preset range comprises:
in a case where the difference value between the second flow rate and the first flow rate is greater than a maximum value of a second preset range, decreasing the rotation speed of the first liquid pump; in a case where the difference value between the second flow rate and the first flow rate is less than a minimum value of the second preset range, increasing the rotation speed of the first liquid pump; or
in a case where the difference value between the second flow rate and the first flow rate is greater than the maximum value of the second preset range, increasing the opening degree of the second regulating valve; in a case where the difference value between the second flow rate and the first flow rate is less than the minimum value of the second preset range, decreasing the opening degree of the second regulating valve; or
in a case where the difference value between the second flow rate and the first flow rate is greater than the maximum value of the second preset range, decreasing the rotation speed of the first liquid pump; in a case where the rotation speed of the first liquid pump is decreased to a threshold value and the difference value between the second flow rate and the first flow rate is still greater than the maximum value of the second preset range, increasing the opening degree of the second regulating valve;
in a case where the difference value between the second flow rate and the first flow rate is less than the minimum value of the second preset range, decreasing the opening degree of the second regulating valve; in a case where the second regulating valve is closed and the difference value between the second flow rate and the first flow rate is still less than the minimum value of the second preset range, increasing the rotation speed of the first liquid pump.

In one possible implementation, in the control method for a liquid cooling system provided by the present invention, the adjusting of a rotation speed of the first liquid pump and/or an opening degree of the second regulating valve in a case where the operating parameter does not fall within a preset range comprises:
in a case where the first temperature is less than a minimum value of a third preset range, decreasing the rotation speed of the first liquid pump; in a case where the first temperature is greater than a maximum value of the third preset range, increasing the rotation speed of the first liquid pump; or
in a case where the first temperature is less than the minimum value of the third preset range, increasing the opening degree of the second regulating valve; in a case where the first temperature is greater than the maximum value of the third preset range, decreasing the opening degree of the second regulating valve; or
in a case where the first temperature is less than the minimum value of the third preset range, decreasing the rotation speed of the first liquid pump; in a case where the rotation speed of the first liquid pump is decreased to a threshold value and the first temperature is still less than the minimum value of the third preset range, increasing the opening degree of the second regulating valve;
in a case where the first temperature is greater than the maximum value of the third preset range, decreasing the opening degree of the second regulating valve; in a case where the second regulating valve is closed and the first temperature is still greater than the maximum value of the third preset range, increasing the rotation speed of the first liquid pump.

In one possible implementation, in the control method for a liquid cooling system provided by the present invention, in a case where the operating parameter does not fall within the preset range, the method further comprises:
acquiring a second temperature of a coolant at a liquid outlet corresponding to each cavity;
regulating a corresponding first regulating valve according to the second temperature.

In a third aspect, the present invention provides a control system for a liquid cooling system, comprising:
a first pressure detection unit being used to detect a first pressure of a coolant at a liquid inlet end of a first liquid pump;
a second pressure detection unit being used to detect a second pressure of a coolant at a liquid outlet end of the first liquid pump;
a control unit to which both the first pressure detection unit and the second pressure detection unit are electrically connected, the control unit being used to adjust a rotation speed of the first liquid pump and/or an opening degree of a second regulating valve in a case where a difference value between the second pressure and the first pressure does not fall within a first preset range.

In a fourth aspect, the present invention provides a control system for a liquid cooling system, comprising:
a first flow rate detection unit being used to detect a first flow rate of a coolant at a liquid inlet end of a first liquid pump;
a second flow rate detection unit being used to detect a second flow rate of a coolant at a liquid outlet end of the first liquid pump;
a control unit to which both the first flow rate detection unit and the second flow rate detection unit are electrically connected, the control unit being used to adjust a rotation speed of the first liquid pump and/or an opening degree of a second regulating valve in a case where a difference value between the second flow rate and the first flow rate does not fall within a second preset range.

In a fifth aspect, the present invention provides a control system for a liquid cooling system, comprising:
a temperature detection unit being used to detect a first temperature of a coolant at a liquid inlet end of a first liquid pump;
a control unit to which the temperature detection unit is electrically connected, the control unit being used to adjust a rotation speed of the first liquid pump and/or an opening degree of a second regulating valve in a case where the first temperature does not fall within a third preset range.

### BRIEF DESCRIPTION OF THE DRAWINGS

In order to more clearly illustrate embodiments of the present invention or technical solutions in the prior arts, figures required to be used in the description of the embodiments or the prior arts will be simply introduced below. Obviously, the figures described below are some embodiments of the present invention. For those ordinarily skilled in the art, other figures may also be obtained in accordance with these figures without exercise of creative work.
Figure 1 is a structural schematic diagram of a liquid cooling system provided in an embodiment of the present invention;
Figure 2 is a structural schematic diagram of a cooling unit in the liquid cooling system provided in the embodiment of the present invention;
Figure 3 is a top view of Figure 2;
Figure 4 is a left view of Figure 2;
Figure 5 is another structural schematic diagram of the liquid cooling system provided in the embodiment of the present invention;
Figure 6 is another structural schematic diagram of the cooling unit in the liquid cooling system provided in the embodiment of the present invention;
Figure 7 is a top view of Figure 6;
Figure 8 is a left view of Figure 6;
Figure 9 is yet another structural schematic diagram of the cooling unit in the liquid cooling system provided in the embodiment of the present invention;
Figure 10 is a schematic flowchart of a control method for the liquid cooling system provided in the embodiment of the present invention;
Figure 11 is a structural schematic diagram of a control device for the liquid cooling system provided in the embodiment of the present invention;
Figure 12 is another structural schematic diagram of the control device for the liquid cooling system provided in the embodiment of the present invention;
Figure 13 is yet another structural schematic diagram of the control device for the liquid cooling system provided in the embodiment of the present invention.

### Description of reference numerals:

100-Heat exchange unit; 110-First liquid pump; 120-Heat exchanger;
200-Cooling unit; 210-Cavity; 220-Liquid inlet; 230-Liquid outlet; 240-First regulating valve; 250-First subunit; 260-Second subunit; 261-Cabinet; 262-Liquid inlet pipe; 263-Liquid outlet pipe; 264-Partition;
300-Second regulating valve;
400 - Filter;
500-Fluid distributor;
600-Liquid replenishing unit; 610-Liquid storage tank; 620-Second liquid pump;
700-First pressure detection unit;
800- Second pressure detection unit
900-Temperature detection unit;
1000-Control unit;
1100-First flow rate detection unit;
1200-Second flow rate detection unit.

### DETAILED DESCRIPTION OF THE INVENTION

In the description of the present invention, it should be noted that, unless otherwise explicitly specified and limited, the terms "install", "interconnect" and "connect" should be understood in a broad sense. For example, they may indicate a fixed connection, may also indicate an indirect interconnection through an intermediate medium, and may indicate internal communication between two elements or an interaction relationship between two elements. For those ordinarily skilled in the art, the specific meanings of the above-mentioned terms in the present invention can be understood according to specific circumstances.

In the description of the present invention, it should be understood that, the orientation or position relationships indicated by the terms such as "upper", "lower", "front", "back", "vertical", "horizontal", "top", "bottom", "inner" and "outer" are based on the orientation or position relationships as shown in the figures, aim only for the convenience of describing the present invention and simplifying the description, instead of indicating or implying that the device or element as referred to must have a specific orientation and be constructed and operated in a specific orientation, and therefore cannot be understood as limitations to the present invention.

The terms "first", "second" and "third" (if present) in the description and the claims of the present invention and the above-mentioned figures are used to distinguish similar objects, but are not necessarily used to describe specific sequences or temporal orders. It should be understood that, the terms used as such are interchangeable under appropriate circumstances so that the embodiments of the present invention described herein, for example, can be implemented in sequences other than those illustrated or described herein.

Furthermore, the terms "include" and "have" and any variations thereof are intended to cover a non-exclusive inclusion. For example, a process, method, system, product or maintenance tool that includes a series of steps or units is not necessarily limited to those steps or units clearly listed, but may include other steps or units not clearly listed or inherent to such processes, methods, products or maintenance tools.

In order to make the purposes, technical solutions and advantages of the embodiments of the present invention clearer, the technical solutions in the embodiments of the present invention will be clearly and completely described below in conjunction with the figures in the embodiments of the present invention. Obviously, the embodiments as described are only part of the embodiments of the present invention, but not all of the embodiments. Based on the embodiments in the present invention, all other embodiments obtained by those ordinarily skilled in the field without exercise of creative work fall within the scope of protection of the present invention.

In related technologies, a server is placed in a cabinet, there is a coolant in the cabinet, the server is immersed in the coolant, and circulation of the coolant is realized by a pump, thereby satisfying continuous heat dissipation requirements of the server. However, according to the development route of conventional data centers, infrastructure planning and construction will be much larger than actual operation in an initial stage, and thus in the actual operation in the initial stage, the server requires smaller installation space and coolant amount. Therefore, an amount of energy consumed for coolant flowing and heat exchange in a cooling loop is larger.

In order to solve the above-mentioned technical problems, the present invention provides a liquid cooling system, and a control system and method for the liquid cooling system. A cooling unit in the liquid cooling system comprises at least two cavities separated from each other. The cooling unit is provided thereon with at least two liquid inlets and at least two liquid outlets. One of the liquid inlets and one of the liquid outlets both correspond to one cavity and are communicated with each other. In this way, during operation in an initial stage, some cavities can be enabled to install a server or electronic devices and be filled with a coolant, and remaining cavities are empty. Alternatively, all cavities are provided with a coolant, but circulation is performed only for the coolant in cavities where a server or electronic devices are installed. In this way, energy consumed for coolant flowing and heat exchange in the cooling loop is reduced. Moreover, a liquid inlet end of the heat exchange unit is provided with a second regulating valve, which can regulate a flow rate of a coolant entering the cooling unit from the heat exchange unit according to a load size (the magnitude of an amount of heat emanated by the server or the electronic devices), thereby being conducive to reducing consumption of energy.

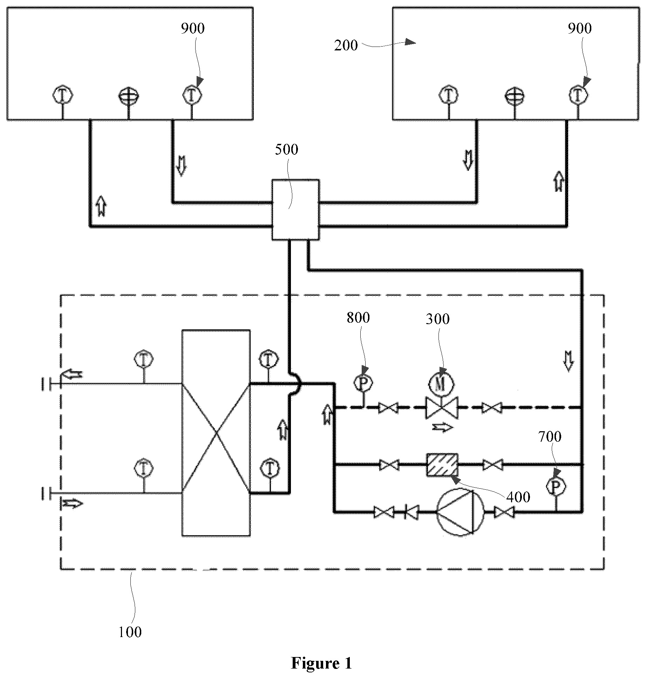

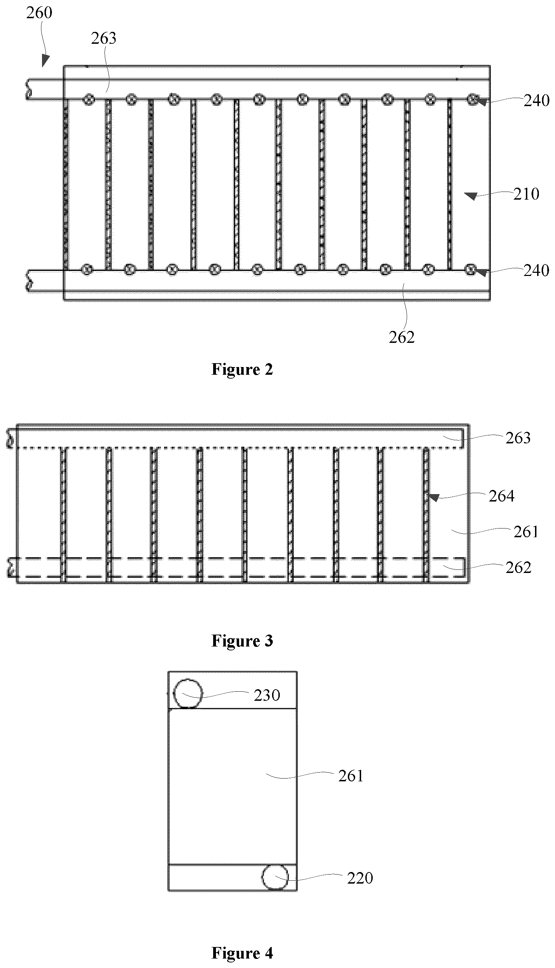

Figure 1 is a structural schematic diagram of a liquid cooling system provided in an embodiment of the present invention. Figure 2 is a structural schematic diagram of a cooling unit in the liquid cooling system provided in the embodiment of the present invention. Figure 3 is a top view of Figure 2. Figure 4 is a left view of Figure 2.

Referring to Figures 1 to 4, the liquid cooling system provided by the present invention comprises a heat exchange unit 100 and a cooling unit 200. The cooling unit 200 comprises at least two cavities 210 separated from each other. The cooling unit 200 is provided thereon with at least two liquid inlets 220 and at least two liquid outlets 230. One liquid inlet 220 and one liquid outlet 230 both correspond to one cavity 210 and are communicated with each other.

Each of the cavities 210 is communicated with the heat exchange unit 100 through the corresponding liquid inlet 220 and liquid outlet 230 to form a cooling loop. Each of the liquid inlets 220 and each of the liquid outlets 230 are provided with a first regulating valve 240, and a liquid inlet end of the heat exchange unit is provided with a second regulating valve 300.

Wherein, the cavities 210 are used to install a server and electronic devices. A coolant is injected into the cavities 210, for immersing the server and the electronic devices, so as to cool the server and the electronic devices.

The coolant is a non-conductive fluid medium. Exemplarily, the coolant may be synthetic oil or a fluorinated liquid type product.

According to the development route of conventional data centers, infrastructure planning and construction will be much larger than actual operation in an initial stage. That is to say, the sum of spaces of all cavities 210 is larger than a space required for installing a server and electronic devices. Therefore, it is possible to inject a coolant into some cavities 210 in the initial stage. In this way, compared with the liquid cooling system having only one cavity 210 in related technologies, an amount of usage of the coolant can be reduced, thereby reducing costs. Moreover, since the amount of usage of the coolant is reduced, energy consumed for coolant circulation and heat exchange in the cooling loop can be reduced.

Alternatively, it is possible to inject a coolant into all cavities 210, and to close a first regulating valve 240 corresponding to a liquid outlet 230 and a liquid inlet 220 which correspond to a cavity 210 where no server and electronic devices are installed, so that the coolant in the cavity 210 where no server and electronic devices are installed does not circulate. In this way, energy consumed for coolant circulation and heat exchange in the cooling loop can be reduced.

In use, the coolant having been subjected to heat exchange and cooling in the heat exchange unit 100 enters the corresponding cavity 210 through the liquid inlet 220, and then enters the heat exchange unit 100 from the cavity 210 through the corresponding liquid outlet 230. The second heat exchange valve can adjust a flow rate of the coolant entered from the heat exchange unit 100 to the cooling unit 200. When the load in the cooling unit 200 is increased, the flow rate of the coolant entered from the heat exchange unit 100 to the cooling unit 200 is increased, and when the load in the cooling unit 200 is decreased, the flow rate of the coolant entered from the heat exchange unit 100 to the cooling unit 200 is decreased, thereby ensuring a cooling effect and reducing energy consumption.

It should be noted that the first regulating valve 240 may be a mechanical valve or an electronic valve. The second regulating valve 300 may be a mechanical valve or an electronic valve.

The first regulating valve 240 can determine the opening or closing of the first regulating valve 240 according to whether a server and electronic devices are installed in the cavity 210.

Alternatively, the opening or closing of the corresponding first regulating valve 240 can be determined according to a temperature of the coolant in the cavity 210. For example, when the temperature of the coolant in the cavity 210 is equal to or higher than 40 degrees, the first regulating valve 240 which corresponds to the liquid inlet 220 corresponding to the cavity 210 and the first regulating valve 240 which corresponds to the corresponding liquid outlet 230 are opened; and when the temperature of the coolant in the cavity 210 is less than 40 degrees, the first regulating valve 240 which corresponds to the liquid inlet 220 corresponding to the cavity 210 and the first regulating valve 240 which corresponds to the corresponding liquid outlet 230 are closed.

Wherein, the heat exchange unit 100 and the cooling unit 200 can be integrated into an all-in-one machine; alternatively, the heat exchange unit 100 and the cooling unit 200 can be separately arranged. In this embodiment, a position relationship between the heat exchange unit 100 and the cooling unit 200 is not specifically limited here.

The liquid cooling system provided in this embodiment is provided with a heat exchange unit 100 and a cooling unit 200. The cooling unit 200 has at least two cavities 210 separated from each other. The cooling unit 200 is provided thereon with at least two liquid inlets 220 and at least two liquid outlets 230. One of the liquid inlets 220 and one of the liquid outlets 230 correspond to one cavity 210 and are communicated with each other. Each of the cavities 210 is communicated with the heat exchange unit 100 through corresponding liquid inlet 220 and liquid outlet 230 to form a cooling loop. Each of the liquid inlets 220 and each of the liquid outlets 230 are provided with a first regulating valve 240, and a liquid inlet end of the heat exchange unit 100 is provided with a second regulating valve 300. In this way, the opening and closing of the first regulating valve 240 can adjust a flow rate of a coolant involved in circulation, and the second regulating valve 300 can adjust a flow rate of a coolant entered from the heat exchange unit 100 to the cooling unit 200, which is helpful for reducing energy consumption required for coolant circulation and heat exchange in the cooling loop.

It can be understood that, the liquid cooling system provided in this embodiment consumes less energy, which is conducive for optimizing the power usage effectiveness (PUE) of a data center. The power usage effectiveness is an indicator for evaluating energy efficiency of the data center, which is a ratio of all energy consumed by the data center to energy used by an IT load.

In one possible implementation, the heat exchange unit 100 comprises a first liquid pump 110 and a heat exchanger 120, a liquid inlet end of the first liquid pump 110 forms a liquid inlet end of the heat exchange unit 100, the first liquid pump 110 is connected to the heat exchanger 120, and the first liquid pump 110 is connected to each of the liquid outlets 230 while the heat exchanger 120 is connected to each of the liquid inlets 220.

Wherein, the first liquid pump 110 is used to provide power for the circulation of the coolant. The number of the first liquid pump 110 may be one, two, or more. Two or more first liquid pumps 110 are arranged in series. A liquid inlet end of the first liquid pump forms a liquid inlet end of the heat exchange unit 100.

Specifically, the first liquid pump 110 may be a speed-adjustable pump, so as to adjust a flow rate of the coolant entered from the heat exchange unit 100 to the cooling unit 200.

The heat exchanger 120 may be a shell and tube type or plate type heat exchanger. The heat exchanger 120 is used for heat exchange between a primary side and a secondary side, thereby decreasing a temperature of the coolant. Exemplarily, the primary side may be a cooling tower, a dry cooler, a chiller, etc., which is not specifically limited here in this embodiment.

In this embodiment, a liquid inlet end of the second regulating valve 300 is connected to a liquid outlet end of the first liquid pump 110, and a liquid outlet end of the second regulating valve 300 is connected to a liquid inlet end of the first liquid pump 110. In this way, the second regulating valve 300 forms a bypass pipeline for the first liquid pump 110. One part of the coolant sprayed by the first liquid pump 110 enters the heat exchanger 120 for cooling, and the other part thereof enters the second regulating valve 300 and returns to the first liquid pump 110 through the second regulating valve 300. The magnitude of a flow rate of the coolant delivered from the second liquid pump to the heat exchanger can be adjusted by means of the magnitude of an opening degree of the second regulating valve 300.

The coolant may have changes in water absorption or chemical property. The coolant is required to be filtered and treated when being used. Therefore, in some embodiments, the liquid cooling system further comprises a filter 400, a liquid inlet end of the filter 400 is connected to a liquid outlet end of the first liquid pump 110, and a liquid outlet end of the filter 400 is connected to a liquid inlet end of the first liquid pump 110. In this way, the filter 400 forms a bypass pipeline for the first liquid pump 110. One part of the coolant sprayed by the first liquid pump 110 enters the heat exchanger 120 for cooling, one part thereof enters the second regulating valve 300 and returns to the first liquid pump 110 through the second regulating valve 300, and a remaining part thereof enters the filter 400 and returns to the first liquid pump 110 after being filtered by the filter 400. In this way, the filter 400 is located in a bypass branch of the first liquid pump 110, which reduces the resistance of the coolant flowing in the cooling loop and is helpful for reducing power consumption.

In some embodiments, the liquid inlet end of the filter 400 is connected to the cooling unit 200, and the liquid outlet end of the filter 400 is connected to the liquid inlet end of the first liquid pump 110.

It can be understood that, by arranging the filter 400, it is conducive for ensuring the cleanliness and chemical stability of the coolant.

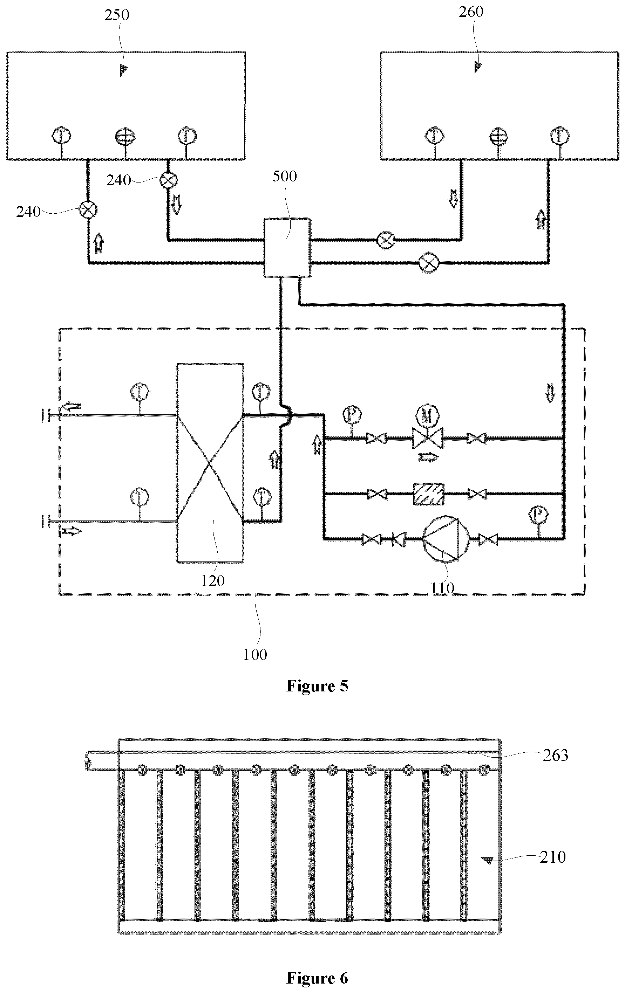

Figure 5 is another structural schematic diagram of the liquid cooling system provided in the embodiment of the present invention.

Referring to Figure 5, the cooling unit 200 comprises at least two first subunits 250, and the first subunit 250 has one cavity 120. In this way, at least two cavities 210 can be formed by means of at least two first subunits 250.

It can be understood that, a first regulating valve 240 which corresponds to a liquid inlet 220 and a liquid outlet 230 in a first subunit 250 can be arranged either on the first subunit 250 or in an external pipeline connected to the first subunit 250.

Exemplarily, the number of the first subunits 250 may be two or more.

Referring to Figures 1 to 4, the cooling unit 200 comprises at least one second subunit 260, and the second subunit 260 has a plurality of cavities 210.

Exemplarily, the cooling unit 200 may comprise at least one first subunit 250 and at least one second subunit 260.

In some embodiments, the second subunit 260 comprises a cabinet 261, a liquid inlet pipe 262, and a liquid outlet pipe 263. An inner cavity of the cabinet 261 is provided with at least one partition 264 which separates the inner cavity into at least two cavities 210. Both the liquid inlets 220 and the liquid outlets 230 are arranged on the cabinet 261.

The liquid inlet pipe 262 and the liquid outlet pipe 263 are located on two opposite sides of the cabinet 261. The liquid inlets 220 are each communicated with the liquid inlet pipe 262. The liquid outlets 230 are each communicated with the liquid outlet pipe 263. It can be understood that, by arranging the liquid inlet pipe 262 and the liquid outlet pipe 263, the heat exchanger 120 is connected to the cooling unit 200 through the liquid inlet pipe 262, and the first liquid pump 110 is connected to the cooling unit 200 through the liquid outlet pipe 263, which can simplify pipelines and facilitate pipeline layout.

Exemplarily, the number of the partitions 264 may be one, two, or more.

Referring to Figures 1 to 4, the number of the partitions 264 may be nine, and the nine partitions 264 separate the inner cavity of the cabinet 261 into ten cavities 210.

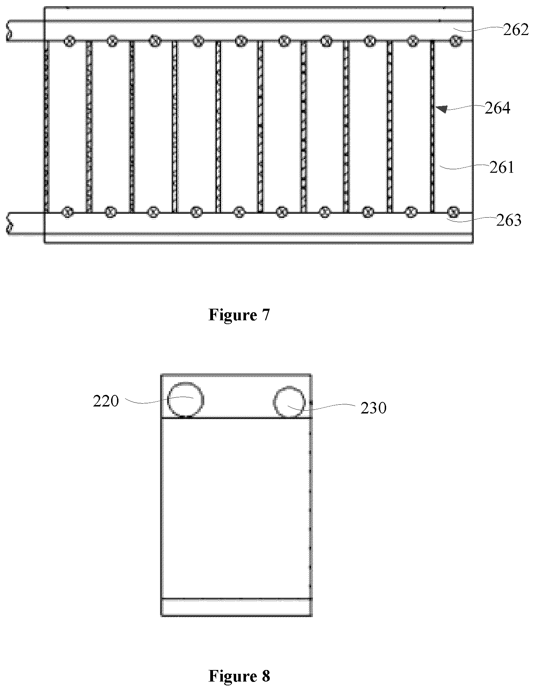

Figure 6 is another structural schematic diagram of the cooling unit in the liquid cooling system provided in the embodiment of the present invention. Figure 7 is a top view of Figure 6. Figure 8 is a left view of Figure 6.

Referring to Figures 6 to 8, both the liquid inlets 220 and the liquid outlets 230 are close to a top of the cooling unit 200. It can be understood that, the density of a coolant with a lower temperature is greater than the density of a coolant with a higher temperature, both the liquid inlets 220 and the liquid outlets 230 are close to the top of the cooling unit 200, and in this way, a coolant with a lower temperature that enters the cavity 210 from the liquid inlet 220 moves toward a bottom, which is conducive to improving the uniformity of the temperature of the coolant in the cavity 210.

Alternatively, one group of the liquid inlets 220 and the liquid outlets 230 is close to the top of the cooling unit 200, and the other group thereof is close to a bottom of the cooling unit 200.

Specifically, referring to Figure 4, the liquid inlets 220 are close to the bottom of the cooling unit 200, the liquid outlets 230 are close to the top of the cooling unit 200, and in this way, a temperature of the coolant close to the bottom of the cooling unit 200 is lower than a temperature of the coolant close to the top of the cooling unit 200. The coolant close to the top of the cooling unit 200 flows out through the liquid inlets 220, which can improve a cooling effect of the coolant.

It should be noted that, in specific implementation, positions of the liquid inlets 220 and the liquid outlets 230 may be set according to layout requirements, so as to facilitate the layout of the liquid cooling system.

Referring to Figures 1 and 5, the liquid cooling system further comprises a fluid distributor 500 being located between the cooling unit 200 and the heat exchange unit 100, which are both connected to the fluid distributor 500.

It can be understood that, a flow rate of a coolant distributed to each first subunit 250 or each second subunit 260 of the cooling unit 200 can be adjusted by controlling the fluid distributor 500.

Wherein, the fluid distributor 500 may be a manifold.

It should be noted that, the flow rate of the coolant distributed to each first subunit 250 or each second subunit 260 of the cooling unit 200 can be adjusted either by controlling the fluid distributor or by controlling an opening degree of the first regulating valve 240, or by controlling both the fluid distributor 500 and the first regulating valve 240.

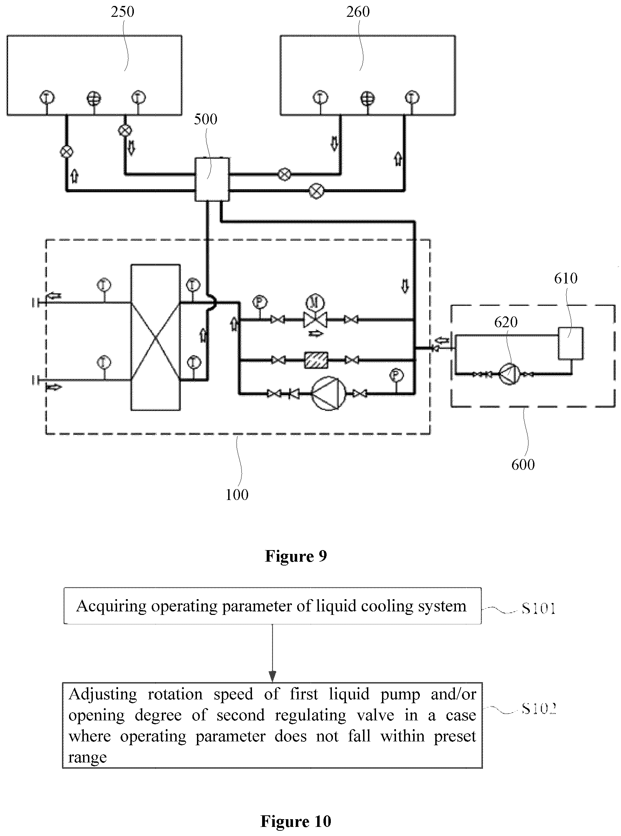

Figure 9 is yet another structural schematic diagram of the cooling unit in the liquid cooling system provided in the embodiment of the present invention.

Referring to Figure 9, the liquid cooling system further comprises a liquid replenishing unit 600, which comprises a liquid storage tank 610 and a second liquid pump 620, the second liquid pump 620 being connected to the liquid storage tank 610, and the second liquid pump 620 being connected to the first liquid pump 110.

It can be understood that, when the load is increased or more cavities 210 are enabled, the liquid cooling system is required to be replenished with a coolant, and automatic replenishment of the coolant can be achieved by arranging a liquid replenishing unit 600.

Figure 10 is a schematic flowchart of a control method for the liquid cooling system provided in the embodiment of the present invention.

Referring to Figure 10, the present invention provides a control method for a liquid cooling system, which is used to control the liquid cooling system provided in the above-mentioned embodiments, the control method comprising S101 and S102.

S101. Acquiring an operating parameter of the liquid cooling system.

Specifically, the operating parameter may be a difference value between a second pressure of a coolant at a liquid outlet of the first liquid pump 110 and a first pressure of a coolant at a liquid inlet of the first liquid pump 110, a difference value between a second flow rate of a coolant at a liquid outlet of the first liquid pump 110 and a first flow rate of a coolant at a liquid inlet of the first liquid pump 110, a first temperature of a coolant at a liquid inlet of the first liquid pump 110, a second temperature of a coolant at a liquid outlet 230 corresponding to each cavity 210, and a third temperature of a coolant in each cavity 210.

S102: Adjusting a rotation speed of a first liquid pump 110 and/or an opening degree of a second regulating valve 300 in a case where the operating parameter does not fall within a preset range.

Exemplarily, the operating parameter may be a second temperature of a coolant at a liquid outlet 230 corresponding to each cavity 210. In a case where one of second temperatures of coolants at liquid outlets 230 corresponding to cavities 210 is greater than a maximum value of a preset range, the rotation speed of the first liquid pump 110 is increased. In a case where all of the second temperatures of the coolants at the liquid outlets 230 corresponding to the cavities 210 are less than a minimum value of the preset range, the rotation speed of the first liquid pump 110 is decreased.

Alternatively, in a case where one of the second temperatures of the coolants at the liquid outlets 230 corresponding to the cavities 210 is greater than the maximum value of the preset range, the opening degree of the second regulating valve 300 is decreased, and in a case where all of the second temperatures of the coolants at the liquid outlets 230 corresponding to the cavities 210 are less than the minimum value of the preset range, the opening degree of the second regulating valve 300 is increased.

Alternatively, in a case where all of the second temperatures of the coolants at the liquid outlets 230 corresponding to the cavities 210 are less than the minimum value of the preset range, the rotation speed of the first liquid pump 110 is decreased.

In a case where the rotation speed of the first liquid pump 110 is decreased to a threshold value and the first temperature is still less than the minimum value of the preset range, the opening degree of the second regulating valve 300 is increased.

In a case where one of the second temperatures of the coolants at the liquid outlets 230 corresponding to the cavities 210 is greater than the maximum value of the preset range, the opening degree of the second regulating valve 300 is decreased.

In a case where the second regulating valve 300 is closed and the first temperature is still greater than the maximum value of the preset range, the rotation speed of the first liquid pump 110 is increased.

Similarly, the operating parameter may be a third temperature of a coolant in each cavity 210, which will not be repeatedly described in this embodiment.

The control method of the liquid cooling system provided by this embodiment acquires an operating parameter of the liquid cooling system. In a case where the parameter does not fall within a preset range, the rotation speed of the first liquid pump 110 and/or the opening degree of the second regulating valve 300 are/is adjusted. In this way, a flow rate of the coolant entered from the heat exchange unit 110 to the cooling unit 200 can be adjusted, which is conducive to reducing energy consumption required for coolant circulation and heat exchange in the cooling loop.

In one possible implementation, the acquiring an operating parameter of the liquid cooling system comprises:
acquiring a first pressure of a coolant at a liquid inlet end of the first liquid pump 110 and a second pressure of a coolant at a liquid outlet end of the first liquid pump 110 to obtain a difference value between the second pressure and the first pressure.

Specifically, in a case where the difference value between the second pressure and the first pressure is greater than a maximum value of a first preset range, the rotation speed of the first liquid pump 110 is decreased.

In a case where the difference value between the second pressure and the first pressure is less than a minimum value of the first preset range, the rotation speed of the first liquid pump 110 is increased.

Alternatively, in a case where the difference value between the second pressure and the first pressure is greater than the maximum value of the first preset range, the opening degree of the second regulating valve 300 is increased.

In a case where the difference value between the second pressure and the first pressure is less than the minimum value of the first preset range, the opening degree of the second regulating valve 300 is decreased.

Further alternatively, in a case where the difference value between the second pressure and the first pressure is greater than the maximum value of the first preset range, the rotation speed of the first liquid pump 110 is decreased.

In a case where the rotation speed of the first liquid pump is decreased to a threshold value and the difference value between the second pressure and the first pressure is still greater than the maximum value of the first preset range, the opening degree of the second regulating valve 300 is increased.

In a case where the difference value between the second pressure and the first pressure is less than the minimum value of the first preset range, the opening degree of the second regulating valve 300 is decreased.

In a case where the second regulating valve 300 is closed and the difference value between the second pressure and the first pressure is still less than the minimum value of the first preset range, the rotation speed of the first liquid pump 110 is increased.

Specifically, the first liquid pump 110 is a speed-adjustable pump. A flow rate of the first liquid pump 110 is proportional to a rotation speed of the first liquid pump 110, and a head of the first liquid pump 110 is proportional to the square of the rotation speed of the first liquid pump 110. That is to say, when the rotation speed of the first liquid pump 110 is increased, the head of the first liquid pump 110 is increased, and the flow rate of the first liquid pump 110 is increased. When the rotation speed of the first liquid pump 110 is decreased, the head of the first liquid pump 110 is decreased, and the flow rate of the first liquid pump 110 is decreased.

The difference value between the second pressure and the first pressure is positively correlated with the head of the first liquid pump 110. In a case where the difference value between the second pressure and the first pressure is greater than the maximum value of the first preset range, it is meant that the head of the first liquid pump 110 is greater and the rotation speed of the first liquid pump 110 is greater, that is to say, the flow rate of the first liquid pump 110 is greater. At this time, an actual flow rate of the coolant per unit time of the cooling unit 200 is greater than a flow rate of the coolant per unit time required by the cooling unit 200, that is to say, it is necessary to decrease the actual flow rate of the coolant per unit time of the cooling unit 200. Therefore, it is necessary to decrease the rotation speed of the first liquid pump 110, or to increase the opening degree of the second regulating valve 300, or to decrease the rotation speed of the first liquid pump 110 while increasing the opening degree of the second regulating valve 300.

In a case where the difference between the second pressure and the first pressure is less than the minimum value of the first preset range, it is meant that the flow rate of coolant required by the cooling unit 200 per unit time is increased. Therefore, it is necessary to increase the rotation speed of the first liquid pump 110, or to decrease the opening degree of the second regulating valve 300, or to increase the rotation speed of the first liquid pump 110 while decreasing the opening degree of the second regulating valve 300.

The control method of the liquid cooling system provided in this embodiment acquires a first pressure of a coolant at a liquid inlet end of the first liquid pump 110 and a second pressure of a coolant at a liquid outlet end of the first liquid pump 110. In a case where a difference value between the second pressure and the first pressure does not fall within a first preset range, the rotation speed of the first liquid pump 110 and/or the opening degree of the second regulating valve 300 are/is adjusted. In this way, a flow rate of the coolant delivered from the heat exchange unit 100 to the cooling unit 200 can be controlled, thereby reducing energy consumption and being conducive to optimizing the PUE of a data center.

Wherein, the first preset range may be 0.8-3bar. The threshold value is a rated minimum rotation speed value of a first hydraulic pump.

In the actual operation in the initial stage, the number of the installed server and electronic devices is smaller, the number of the enabled cavities 210 is smaller, the heat generated by the installed server and electronic devices is smaller, and the load of the liquid cooling system is lower. Thus, after the rotation speed of the first hydraulic pump drops to the rated minimum rotation speed value, the difference value between the second pressure and the first pressure is still greater than the first preset range. At this time, the second regulating valve 300 is opened, and the opening degree of the second regulating valve 300 is adjusted, so that the difference value between the second pressure and the first pressure falls within the first preset range, which is thus conducive to reducing the consumption of energy of the first liquid pump 110 and can ensure the first liquid pump 110 to operate within a rated rotation speed range.

In a case where the difference value between the second pressure and the first pressure is less than the minimum value of the first preset range, the opening degree of the second valve is first adjusted until the second valve is closed and then the rotation speed of the first liquid pump 110 is increased, which is thus conducive to reducing the consumption of energy of the first liquid pump 110.

In another possible implementation, in the control method of the liquid cooling system provided by the present invention, the acquiring an operating parameter of the liquid cooling system comprises:
acquiring a first flow rate of a coolant at a liquid inlet end of the first liquid pump 110 and a second flow rate of a coolant at a liquid outlet end of the first liquid pump 110 to obtain a difference value between the second flow rate and the first flow rate.

Specifically, in a case where the difference value between the second flow rate and the first flow rate is greater than a maximum value of a second preset range, the rotation speed of the first liquid pump 110 is decreased.

In a case where the difference value between the second flow rate and the first flow rate is less than a minimum value of the second preset range, the rotation speed of the first liquid pump 110 is increased.

Alternatively, in a case where the difference value between the second flow rate and the first flow rate is greater than the maximum value of the second preset range, the opening degree of the second regulating valve 300 is increased.

In a case where the difference value between the second flow rate and the first flow rate is less than the minimum value of the second preset range, the opening degree of the second regulating valve 300 is decreased.

Further alternatively, in a case where the difference value between the second flow rate and the first flow rate is greater than the maximum value of the second preset range, the rotation speed of the first liquid pump 110 is decreased.

In a case where the rotation speed of the first liquid pump is decreased to a threshold value and the difference value between the second flow rate and the first flow rate is still greater than the maximum value of the second preset range, the opening degree of the second regulating valve 300 is increased.

In a case where the difference value between the second flow rate and the first flow rate is less than the minimum value of the second preset range, the opening degree of the second regulating valve 300 is decreased.

In a case where the second regulating valve 300 is closed and the difference value between the second flow rate and the first flow rate is still less than the minimum value of the second preset range, the rotation speed of the first liquid pump 110 is increased.

The control method of the liquid cooling system provided in this embodiment acquires a first flow rate of a coolant at a liquid inlet end of the first liquid pump 110 and a second flow rate of a coolant at a liquid outlet end of the first liquid pump 110. In a case where a difference value between the second flow rate and the first flow rate does not fall within a second preset range, the rotation speed of the first liquid pump 110 and/or the opening degree of the second regulating valve 300 are/is adjusted. In this way, a flow rate of the coolant delivered from the heat exchange unit 100 to the cooling unit 200 can be controlled, thereby reducing energy consumption and being conducive to optimizing the PUE of a data center.

Wherein, the second preset range may be set based on the first preset range.

In the actual operation in the initial stage, the number of the installed server and electronic devices is smaller, the number of the enabled cavities 210 is smaller, the heat generated by the installed server and electronic devices is smaller, and the load of the liquid cooling system is lower. Thus, after the rotation speed of the first hydraulic pump drops to the rated minimum rotation speed value, the difference value between the second flow rate and the first flow rate is still greater than the second preset range. At this time, the second regulating valve 300 is opened, and the opening degree of the second regulating valve 300 is adjusted, so that the difference value between the second flow rate and the first flow rate falls within the second preset range, which is thus conducive to reducing the consumption of energy of the first liquid pump 110 and can ensure the first liquid pump 110 to operate within a rated rotation speed range.

In a case where the difference value between the second flow rate and the first flow rate is less than the minimum value of the second preset range, the opening degree of the second valve is first adjusted until the second valve is closed and then the rotation speed of the first liquid pump 110 is increased, which is thus conducive to reducing the consumption of energy of the first liquid pump 110.

In some embodiments, in the control method of the liquid cooling system provided by the present invention, the acquiring an operating parameter of the liquid cooling system comprises:
acquiring a first temperature of a coolant at a liquid inlet end of the first liquid pump 110.

It should be noted that, in a case where the first temperature is less than a minimum value of a third preset range, the rotation speed of the first liquid pump 110 is decreased, and in a case where the first temperature is greater than a maximum value of the third preset range, the rotation speed of the first liquid pump 110 is increased.

Alternatively, in a case where the first temperature is less than the minimum value of the third preset range, the opening degree of the second regulating valve 300 is increased.

In a case where the first temperature is greater than the maximum value of the third preset range, the opening degree of the second regulating valve 300 is decreased.

Further alternatively, in a case where the first temperature is less than the minimum value of the third preset range, the rotation speed of the first liquid pump 110 is decreased.

In a case where the rotation speed of the first liquid pump 110 is decreased to a threshold value and the first temperature is still less than the minimum value of the third preset range, the opening degree of the second regulating valve 300 is increased.

In a case where the first temperature is greater than the maximum value of the third preset range, the opening degree of the second regulating valve 300 is decreased.

In a case where the second regulating valve 300 is closed and the first temperature is still greater than the maximum value of the third preset range, the rotation speed of the first liquid pump 110 is increased.

It can be understood that, in a case where the first temperature is less than the minimum value of the third preset range, it is meant that the flow rate of the coolant required by the cooling unit 200 is decreased. Therefore, it is necessary to reduce the rotation speed of the first liquid pump 110, or to increase the opening degree of the second regulating valve 300, or to reduce the rotation speed of the first liquid pump 110 while increasing the opening degree of the second regulating valve 300.

In a case where the first temperature is greater than the maximum value of the third preset range, it is meant that the flow rate of coolant required by the cooling unit 200 is increased. Therefore, it is necessary to increase the rotation speed of the first liquid pump 110, or to decrease the opening degree of the second regulating valve 300, or to increase the rotation speed of the first liquid pump 110 while decreasing the opening degree of the second regulating valve 300.

The control method of the liquid cooling system provided in this embodiment acquires a first temperature of a coolant at the liquid inlet end of the first liquid pump 110. In a case where the first temperature does not fall within a third preset range, the rotation speed of the first liquid pump 110 and/or the opening degree of the second regulating valve 300 are/is adjusted. In this way, a flow rate of the coolant delivered from the heat exchange unit 100 to the cooling unit 200 can be controlled, thereby reducing energy consumption and being conducive to optimizing the PUE of a data center.

Wherein, the third preset range may be 40°-65°.

It can be understood that, when the first temperature is greater than 65°, a cooling effect of the coolant is worse, and when the first temperature is less than 40°, an amount of energy consumption in a circulation process of the coolant is larger.

In the actual operation in the initial stage, the number of the installed server and electronic devices is smaller, the number of the enabled cavities 210 is smaller, the heat generated by the installed server and electronic devices is smaller, and the load of the liquid cooling system is lower. Thus, after the rotation speed of the first hydraulic pump drops to the rated minimum rotation speed value and the first temperature is still less than the minimum value of the third preset range, the second regulating valve 300 is opened, and the opening degree of the second regulating valve 300 is adjusted, so that the first temperature falls within the third preset range, which is thus conducive to reducing the consumption of energy of the first liquid pump 110 and can ensure the first liquid pump 110 to operate within a rated rotation speed range.

In a case where the first temperature is greater than the maximum value of the third preset range, the opening degree of the second regulating valve 300 is first adjusted until the second regulating valve 300 is closed and then the rotation speed of the first liquid pump 110 is increased, which is thus conducive to reducing the consumption of energy of the first liquid pump 110.

In one possible implementation, in a case where the operating parameter does not fall within the preset range, the method further comprises:
acquiring a second temperature of a coolant at a liquid outlet 230 corresponding to each cavity 210;
regulating a corresponding first regulating valve 240 according to the second temperature.

Exemplarily, the cooling unit 200 may include a first cavity and a second cavity, the cooling unit 200 is provided thereon with a first liquid outlet and a second liquid outlet, the first liquid outlet is communicated with the first cavity, the second liquid outlet is communicated with the second cavity, and the first liquid outlet and the second liquid outlet are each provided with a first regulating valve 240. An opening degree of the first regulating valve 240 corresponding to the first liquid outlet is controlled according to a second temperature of a coolant at the first liquid outlet. In a case where the second temperature is greater than a maximum value of a third preset range, the opening degree of the first regulating valve 240 is increased, and in a case where the second temperature is less than a minimum value of the third preset range, the opening degree of the first regulating valve 240 is decreased, with control accuracy being higher. Likewise, an opening degree of the first regulating valve 240 corresponding to the second liquid outlet is controlled according to a second temperature of a coolant at the second liquid outlet, with control accuracy being higher.

It can be understood that, in a case where no server (and/or electronic device) is installed in the first cavity or the second cavity, the second temperature of the coolant at the corresponding liquid outlet 230 is lower, the corresponding first regulating valve 240 can be closed, and energy consumed for coolant circulation and heat exchange in the cooling loop can be reduced.

Moreover, in a case where a server (and/or electronic device) is installed in the first cavity or the second cavity, a second temperature of a coolant at a liquid outlet 230 corresponding to each cavity 210 is detected, thereby being conducive to ensuring a cooling effect of the server (and/or electronic device) in the first cavity and the second cavity.

In some embodiments, the first regulating valve 240 corresponding to the liquid outlet 230 of each cavity 210 can be adjusted according to the first temperature of the coolant at the liquid inlet end of the first liquid pump 110.

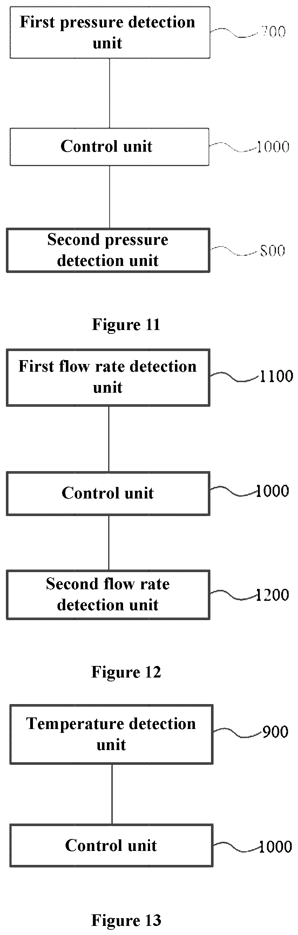

Figure 11 is a structural schematic diagram of a control device for the liquid cooling system provided in the embodiment of the present invention.

Referring to Figure 11, the control system of the liquid cooling system comprises:
a first pressure detection unit 700 being used to detect a first pressure of a coolant at a liquid inlet end of a first liquid pump 110;
a second pressure detection unit 800 being used to detect a second pressure of a coolant at a liquid outlet end of the first liquid pump 110;
a control unit 1000 to which both the first pressure detection unit 700 and the second pressure detection unit 800 are electrically connected, the control unit 1000 being used to adjust a rotation speed of the first liquid pump 110 and/or an opening degree of a second regulating valve 300 in a case where a difference value between the second pressure and the first pressure does not fall within a first preset range.

Specifically, the first pressure detection unit 700 and the second pressure detection unit 800 may be pressure sensors.

Figure 12 is another structural schematic diagram of the control device for the liquid cooling system provided in the embodiment of the present invention.

Referring to Figure 12, the control system of the liquid cooling system provided by the present invention comprises:
a first flow rate detection unit 1100 being used to detect a first flow rate of a coolant at a liquid inlet end of a first liquid pump 110;
a second flow rate detection unit 1200 being used to detect a second flow rate of a coolant at a liquid outlet end of the first liquid pump 110;
a control unit 1000 to which both the first flow rate detection unit 1100 and the second flow rate detection unit 1200 are electrically connected, the control unit 1000 being used to adjust a rotation speed of the first liquid pump 110 and/or an opening degree of a second regulating valve 300 in a case where a difference value between the second flow rate and the first flow rate does not fall within a second preset range.

Specifically, the first flow rate detection unit 1100 and the second flow rate detection unit 1200 may be flow rate sensors.

Figure 13 is yet another structural schematic diagram of the control device for the liquid cooling system provided in the embodiment of the present invention.

Referring to Figure 13, the control system of the liquid cooling system provided by the present invention comprises:
a temperature detection unit 900 being used to detect a first temperature of a coolant at a liquid inlet end of a first liquid pump 110;
a control unit 1000 to which the temperature detection unit 900 is electrically connected, the control unit 1000 being used to adjust a rotation speed of the first liquid pump 110 and/or an opening degree of a second regulating valve 300 in a case where the first temperature does not fall within a third preset range.

Specifically, the temperature detection unit 900 may be a temperature sensor.

Finally, it should be noted that the above-mentioned embodiments are used only to illustrate the technical solutions of the present invention, but not to limit them. Although the present invention has been described in detail with reference to the aforementioned embodiments, those ordinarily skilled in the art should understand that: they can still modify the technical solutions described in the aforementioned embodiments or replace some or all of the technical features therein with equivalents, while these modifications or replacements do not cause the essence of the corresponding technical solutions to depart from the scope of the technical solutions of the embodiments of the present invention.

## Claims

1. A liquid cooling system, **characterized by** comprising a heat exchange unit and a cooling unit, wherein the cooling unit comprises at least two cavities separated from each other, the cooling unit is provided thereon with at least two liquid inlets and at least two liquid outlets, one of the liquid inlets and one of the liquid outlets both correspond to one cavity and are communicated with each other;
each of the cavities is communicated with the heat exchange unit through the corresponding liquid inlet and liquid outlet to form a cooling loop;
each of the liquid inlets and each of the liquid outlets are provided with a first regulating valve, and a liquid inlet end of the heat exchange unit is provided with a second regulating valve.

2. The liquid cooling system according to claim 1, **characterized in that** the heat exchange unit comprises a first liquid pump and a heat exchanger, a liquid inlet end of the first liquid pump forms a liquid inlet end of the heat exchange unit, the first liquid pump is connected to the heat exchanger, and the first liquid pump is connected to each of the liquid outlets while the heat exchanger is connected to each of the liquid inlets.

3. The liquid cooling system according to claim 2, **characterized by** further comprising a filter, wherein a liquid inlet end of the filter is connected to a liquid outlet end of the first liquid pump, and a liquid outlet end of the filter is connected to the liquid inlet end of the first liquid pump, or
the liquid inlet end of the filter is connected to the cooling unit, and the liquid outlet end of the filter is connected to the liquid inlet end of the first liquid pump.

4. The liquid cooling system according to claim 2, **characterized in that** a liquid inlet end of the second regulating valve is connected to a liquid outlet end of the first liquid pump, and a liquid outlet end of the second regulating valve is connected to the liquid inlet end of the first liquid pump.

5. The liquid cooling system according to any one of claims 1 to 4, **characterized in that** the cooling unit comprises at least two first subunits, and the first subunit has one said cavity.

6. The liquid cooling system according to any one of claims 1 to 4, **characterized in that** the cooling unit comprises at least one second subunit, and the second subunit has at least two said cavities.

7. The liquid cooling system according to claim 6, **characterized in that** the second subunit comprises a cabinet, a liquid inlet pipe, and a liquid outlet pipe, an inner cavity of the cabinet is provided with at least one partition which separates the inner cavity into at least two cavities, both the liquid inlets and the liquid outlets are arranged on the cabinet;
the liquid inlet pipe and the liquid outlet pipe are located on two opposite sides of the cabinet, the liquid inlets are each communicated with the liquid inlet pipe, and the liquid outlets are each communicated with the liquid outlet pipe.

8. The liquid cooling system according to any one of claims 1 to 4, **characterized in that** both the liquid inlets and the liquid outlets are close to a top of the cooling unit; or
one group of the liquid inlets and the liquid outlets is close to the top of the cooling unit, and the other group of the liquid inlets and the liquid outlets is close to a bottom of the cooling unit.

9. The liquid cooling system according to any one of claims 1 to 4, **characterized by** further comprising a fluid distributor located between the cooling unit and the heat exchange unit, which are both connected to the fluid distributor.

10. The liquid cooling system according to any one of claims 2 to 4, **characterized by** further comprising a liquid replenishing unit, which comprises a liquid storage tank and a second liquid pump, the second liquid pump being connected to the liquid storage tank, and the second liquid pump being connected to the first liquid pump.

11. A control method for a liquid cooling system, **characterized in that** it is used to control the liquid cooling system according to any one of claims 1 to 10, the control method comprising:
acquiring an operating parameter of the liquid cooling system;
adjusting a rotation speed of a first liquid pump and/or an opening degree of a second regulating valve in a case where the operating parameter does not fall within a preset range.

12. The control method for a liquid cooling system according to claim 11, **characterized in that** the acquiring of an operating parameter of the liquid cooling system comprises:
acquiring a first pressure of a coolant at a liquid inlet end of the first liquid pump and a second pressure of a coolant at a liquid outlet end of the first liquid pump to obtain a difference value between the second pressure and the first pressure.

13. The control method for a liquid cooling system according to claim 11, **characterized in that** the acquiring of an operating parameter of the liquid cooling system comprises:
acquiring a first flow rate of a coolant at a liquid inlet end of the first liquid pump and a second flow rate of a coolant at a liquid outlet end of the first liquid pump to obtain a difference value between the second flow rate and the first flow rate.

14. The control method for a liquid cooling system according to claim 11, **characterized in that** the acquiring of an operating parameter of the liquid cooling system comprises:
acquiring a first temperature of a coolant at a liquid inlet end of the first liquid pump.

15. The control method for a liquid cooling system according to claim 12, **characterized in that** the adjusting of a rotation speed of the first liquid pump and/or an opening degree of the second regulating valve in a case where the operating parameter does not fall within a preset range comprises:
in a case where the difference value between the second pressure and the first pressure is greater than a maximum value of a first preset range, decreasing the rotation speed of the first liquid pump; in a case where the difference value between the second pressure and the first pressure is less than a minimum value of the first preset range, increasing the rotation speed of the first liquid pump; or
in a case where the difference value between the second pressure and the first pressure is greater than the maximum value of the first preset range, increasing the opening degree of the second regulating valve; in a case where the difference value between the second pressure and the first pressure is less than the minimum value of the first preset range, decreasing the opening degree of the second regulating valve; or
in a case where the difference value between the second pressure and the first pressure is greater than the maximum value of the first preset range, decreasing the rotation speed of the first liquid pump; in a case where the rotation speed of the first liquid pump is decreased to a threshold value and the difference value between the second pressure and the first pressure is still greater than the maximum value of the first preset range, increasing the opening degree of the second regulating valve;
in a case where the difference value between the second pressure and the first pressure is less than the minimum value of the first preset range, decreasing the opening degree of the second regulating valve; in a case where the second regulating valve is closed and the difference value between the second pressure and the first pressure is still less than the minimum value of the first preset range, increasing the rotation speed of the first liquid pump.

16. The control method for a liquid cooling system according to claim 13, **characterized in that** the adjusting of a rotation speed of the first liquid pump and/or an opening degree of the second regulating valve in a case where the operating parameter does not fall within a preset range comprises:
in a case where the difference value between the second flow rate and the first flow rate is greater than a maximum value of a second preset range, decreasing the rotation speed of the first liquid pump; in a case where the difference value between the second flow rate and the first flow rate is less than a minimum value of the second preset range, increasing the rotation speed of the first liquid pump; or
in a case where the difference value between the second flow rate and the first flow rate is greater than the maximum value of the second preset range, increasing the opening degree of the second regulating valve; in a case where the difference value between the second flow rate and the first flow rate is less than the minimum value of the second preset range, decreasing the opening degree of the second regulating valve; or
in a case where the difference value between the second flow rate and the first flow rate is greater than the maximum value of the second preset range, decreasing the rotation speed of the first liquid pump; in a case where the rotation speed of the first liquid pump is decreased to a threshold value and the difference value between the second flow rate and the first flow rate is still greater than the maximum value of the second preset range, increasing the opening degree of the second regulating valve;
in a case where the difference value between the second flow rate and the first flow rate is less than the minimum value of the second preset range, decreasing the opening degree of the second regulating valve; in a case where the second regulating valve is closed and the difference value between the second flow rate and the first flow rate is still less than the minimum value of the second preset range, increasing the rotation speed of the first liquid pump.

17. The control method for a liquid cooling system according to claim 14, **characterized in that** the adjusting of a rotation speed of the first liquid pump and/or an opening degree of the second regulating valve in a case where the operating parameter does not fall within a preset range comprises:
in a case where the first temperature is less than a minimum value of a third preset range, decreasing the rotation speed of the first liquid pump; in a case where the first temperature is greater than a maximum value of the third preset range, increasing the rotation speed of the first liquid pump; or
in a case where the first temperature is less than the minimum value of the third preset range, increasing the opening degree of the second regulating valve; in a case where the first temperature is greater than the maximum value of the third preset range, decreasing the opening degree of the second regulating valve; or
in a case where the first temperature is less than the minimum value of the third preset range, decreasing the rotation speed of the first liquid pump; in a case where the rotation speed of the first liquid pump is decreased to a threshold value and the first temperature is still less than the minimum value of the third preset range, increasing the opening degree of the second regulating valve;
in a case where the first temperature is greater than the maximum value of the third preset range, decreasing the opening degree of the second regulating valve; in a case where the second regulating valve is closed and the first temperature is still greater than the maximum value of the third preset range, increasing the rotation speed of the first liquid pump.

18. The control method for a liquid cooling system according to claim 14, **characterized in that** in a case where the operating parameter does not fall within the preset range, the method further comprises:
acquiring a second temperature of a coolant at a liquid outlet corresponding to each cavity;
regulating a corresponding first regulating valve according to the second temperature.

19. A control system for a liquid cooling system, **characterized by** comprising:
a first pressure detection unit being used to detect a first pressure of a coolant at a liquid inlet end of a first liquid pump;
a second pressure detection unit being used to detect a second pressure of a coolant at a liquid outlet end of the first liquid pump;
a control unit to which both the first pressure detection unit and the second pressure detection unit are electrically connected, the control unit being used to adjust a rotation speed of the first liquid pump and/or an opening degree of a second regulating valve in a case where a difference value between the second pressure and the first pressure does not fall within a first preset range.

20. A control system for a liquid cooling system, **characterized by** comprising:
a first flow rate detection unit being used to detect a first flow rate of a coolant at a liquid inlet end of a first liquid pump;
a second flow rate detection unit being used to detect a second flow rate of a coolant at a liquid outlet end of the first liquid pump;
a control unit to which both the first flow rate detection unit and the second flow rate detection unit are electrically connected, the control unit being used to adjust a rotation speed of the first liquid pump and/or an opening degree of a second regulating valve in a case where a difference value between the second flow rate and the first flow rate does not fall within a second preset range.

21. A control system for a liquid cooling system, **characterized by** comprising:
a temperature detection unit being used to detect a first temperature of a coolant at a liquid inlet end of a first liquid pump;
a control unit to which the temperature detection unit is electrically connected, the control unit being used to adjust a rotation speed of the first liquid pump and/or an opening degree of a second regulating valve in a case where the first temperature does not fall within a third preset range.
